# EUROPÄISCHE PATENTSCHRIFT

(11) **EP 0 429 697 B1**
(45) Veröffentlichungstag und Bekanntmachung des Hinweises auf die Patenterteilung: **05.03.1997**
(21) Anmeldenummer: 89121925.5
(22) Anmeldetag: 28.11.1989
(51) Int. Cl.: H01L 23/544, H01L 21/027, H01L 21/338

(54) **Halbleiterscheibe mit dotiertem Ritzrahmen**
Semiconductor wafer with doped kerf-regions
tranche semi-conductrice avec zones de découpe dotées

(43) Veröffentlichungstag der Anmeldung: 05.06.1991
(73) Patentinhaber: SIEMENS AKTIENGESELLSCHAFT, 80333 München (DE)
(72) Erfinder: Ponse, Frederik, Dr., D-8025 Unterhaching (DE); Belle, Gabriele, Dr., D-8000 München 82 (DE); Knapek, Erwin, Dr., D-8025 Unterhaching (DE)

(56) Entgegenhaltungen:
- GB-A- 2 130 788
- IBM TECHNICAL DISCLOSURE BULLETIN, Band 28, Nr. 1, Juni 1985, Seiten 323-326, New York, US; "Voltage contrast registration marks for electron beam lithography"
- IDEM
- SOLID STATE TECHNOLOGY, Band 29, Nr. 6, Juni 1986, Seiten 169-175, Port
- Washington, NY, US; J.F. ALLISON et al.: "Microlithographic techniques for high speed GaAs field effect transistors"

## Beschreibung

Die Erfindung betrifft einen Ritzrahmen für eine Halbleiterscheibe nach dem Oberbegriff des Patentanspruchs 1.

Eine solche Halbleiterscheibe ist beispielsweise aus IBM Technical Disclosure Bulletin 28(1), S. 323-326 bekannt. Hierin ist eine Si-Halbleiterscheibe beschrieben, bei der Justiermarken für Elektronenstrahlen mittels gitterförmig angeordneter Leiterbahnen elektrisch leitend miteinander verbunden sind. Die Justiermarken und Leiterbahnen sind gegen die Si-Halbleiterscheibe elektrisch isoliert und bestehen aus einer Metallschicht oder aus diffundierten oder implantierten Gebieten.

Halbleiterbauelemente werden üblicherweise auf Halbleiterscheiben (Wafern) im Verbund hergestellt. Zur Vereinzelung der im Verbund hergestellten Halbleiterbauelemente sind zwischen den einzelnen Halbleiterbauelementen sogenannte Ritzrahmen vorgesehen. Entlang dieser Ritzrahmen werden die Halbleiterbauelemente durch Sägen oder durch ein anderes einem Fachmann bekannten Trennverfahren vereinzelt. Diese Ritzrahmen sind elektrisch halbleitend. Bei Verwendung von semi-isolierenden Verbindungs-Halbleiter-Substraten sind diese Ritzrahmen sogar semi-isolierend.

Bei der Herstellung von Halbleiterbauelementen, insbesondere bei der Herstellung von Verbindungs-Halbleiterbauelementen, müssen immer kleinere Strukturen, beispielsweise im Sub-Mikron-Bereich erzeugt werden. Zu diesem Zweck werden solche Feinstrukturen zumindest teilweise durch Belichtung irgendwelcher Fotolacke mit Hilfe von Korpuskularstrahl-Schreibern erzeugt. Bei diesem Verfahren sammeln sich elektrische Ladungen auf der Oberfläche der Halbleiterscheibe, beeinflussen dadurch die Position des Korpuskularstrahls und verursachen dadurch eine Verschlechterung der zu erzeugenden Feinstrukturen. Auch beim Suchen von Justiermarken, welche für die Justierung eines Korpuskularstrahls auf der Oberfläche der Halbleiterscheibe vorgesehen sind, entstehen auf dieser Oberfläche Aufladungen, die die Position bzw. die Positionsfindung des Korpuskularstrahls beeinflussen.

Dieses Problem der Aufladungen auf der Oberfläche eines zu erzeugenden Halbleiterbauelements werden üblicherweise durch Aufdampfen einer elektrisch leitenden Schicht, beispielsweise aus Metall (Aluminium), vermieden. In GB-A-2 130 788 ist beispielsweise eine GaAs-Halbleiterscheibe beschrieben, die Justiermarken aufweist, die mittels einer auf der GaAs-Halbleiterscheibe hergestellten gitterartigen Metallschicht untereinander elektrisch leitend verbunden sind. Das Herstellen sowie das Ablösen einer solchen gitterartigen Metallschicht ist jedoch mit großem Aufwand verbunden.

Der vorliegenden Erfindung liegt daher die Aufgabe zugrunde, einen Ritzrahmen nach dem Oberbegriff des Patentanspruchs 1 anzugeben, der eine hinreichende Positionierung eines Korpuskularstrahls ermöglicht.

Diese Aufgabe wird erfindungsgemäß durch einen Ritzrahmen nach dem Patentanspruch 1 gelöst.

Ausgestaltungen und Vorteile der Erfindung sind in den Unteransprüchen, der Beschreibung und der Zeichnung angegeben.

Die Erfindung bietet viele überraschende Vorteile und ist vielfältig anwendbar.

Die Erfindung ist vorteilhaft anwendbar bei semi-isolierenden Halbleiter-Substraten aus Verbindungs-Halbleitermaterial. Solche Verbindungs-Halbleitermaterialien können III-V-Verbindungshalbleiter oder II-VI-Verbindungshalbleiter sein. Semi-isolierende Substrate aus Galliumarsenid besitzen einen hohen spezifischen Widerstand von 10⁷-10⁸ Ohm cm. Die Erfindung ist auch vorteilhaft anwendbar für hochohmige Halbleiter-Substrate, auch für Silizium- oder Germanium-Substrate. Die Erfindung ist vorteilhaft anwendbar für Halbleiter-Substrate mit geringer Leitfähigkeit. Die Erfindung ermöglicht ganz generell bei sämtlichen Halbleiter-Materialien die Erzeugung von Strukturen bzw. Feinstrukturen mit günstigeren Eigenschaften, beispielsweise steilere Kanten oder größere Strukturtreue der zu strukturierenden Bereiche.

Die Erfindung läßt sich beispielsweise dadurch realisieren, daß der Ritzrahmen höher dotiert ist als seine Umgebung. Die elektrische Leitfähigkeit des Ritzrahmens ist vorteilhafterweise so groß, daß elektrische Ladungen von denjenigen Flächen, auf die der Korpuskularstrahl auftrifft, zuverlässig abgeführt werden. Die Größe der dazu erforderlichen elektrischen Leitfähigkeit des Ritzrahmens kann dabei unterschiedliche Werte mit unterschiedlich vorteilhaften Wirkungen aufweisen. Je größer die elektrische Leitfähigkeit des Ritzrahmens ist, desto rascher werden Aufladungen an Auftreffstellen des Korpuskularstrahls abgebaut. Eine extrinsische Leitfähigkeit des Ritzrahmens ist vorteilhaft zum Abführen von Aufladungen an der Auftreffstelle des Korpuskularstrahls.

Bei semi-isolierenden Halbleiter-Substraten ist es günstig, wenn der Ritzrahmen eine Schicht-Konzentration von freien Ladungsträgern von mehr als 10¹⁰cm⁻² aufweist. Ritzrahmen, die eine Ladungsträgerkonzentration von mehr als 10¹²cm⁻² aufweisen, besitzen eine gute elektrische Leitfähigkeit.

Werden Ritzrahmen gleichzeitig mit einem Kanal eines Feldeffekttransistors mittels Implantation hergestellt, so besitzen diese Ritzrahmen vorteilhafterweise eine Schicht-Ladungsträgerkonzentration von 10¹¹cm⁻² oder mehr.

Werden Ritzrahmen gleichzeitig mit einer Kontaktschicht eines Feldeffekttransistors mittels Implantation hergestellt, so besitzen diese Ritzrahmen vorteilhafterweise eine Schicht-Ladungsträgerkonzentration von 10¹²cm⁻² oder mehr.

Vorteilhafterweise werden Flächen, auf die der Korpuskularstrahl auftrifft, oder in deren Nähe der Korpuskularstrahl auftrifft, elektrisch leitend mit dem elektrisch leitenden Ritzrahmen verbunden. Beispielsweise sind solche Flächen die aktiven Bereiche bei Feldeffekttransistoren, die mit Gates versehen werden; beispielsweise sind solche Flächen die Flächen, auf denen sich Justiermarken befinden.

Vorteilhafterweise wird der Ritzrahmen gleichzeitig mit einer ohnehin im Herstellungsprozeß des Halbleiterbauelements vorkommenden Implantation mittels dieser Implantation dotiert. Beispielsweise wird der Ritzrahmen gleichzeitig mit der n-Implantation des Bauelements dotiert. Beispielsweise wird der Ritzrahmen gleichzeitig mit der Implantation des Kanals eines Feldeffekttransistors dotiert. Beispielsweise wird der Ritzrahmen zusammen mit Kontakt-Implantation und/oder zusammen mit Schutzringen implantiert. Beispielsweise wird der Ritzrahmen gleichzeitig mit der Implantation einer Justiermarke dotiert. Der Ritzrahmen kann auch mittels mehrerer Implantationen dotiert werden, insbesondere mittels mehrerer Implantationen, die ohnehin im Herstellungsprozeß des Halbleiterbauelements vorgesehen sind.

Der Ritzrahmen besitzt vorteilhafterweise eine elektrisch leitende Verbindung mit der Source-Zone oder mit der Drain-Zone eines Feldeffekttransistors. Dies ist vorteilhaft, weil dann beim fertigen Bauelement der Ritzrahmen auf einem definierten Potential liegt.

Der elektrisch leitende Ritzrahmen ermöglicht es bei einem semiisolierenden Substrat, daß die Oberfläche dieses Substrats zumindest in Ritzrahmennähe DC-mäßig auf einem definierten Potential liegt. Dadurch, daß die Oberfläche des Halbleiterbauelements auf einem definierten Potential liegen kann, ermöglicht es der Ritzrahmen, daß Sidegating-Effekte unterdrückt werden. Falls diese Eigenschaft nicht gewünscht wird, ist der elektrisch leitende Ritzrahmen ohne weiteres entfernbar, beispielsweise mittels Ätzen, ggf. selbstjustierend mit der Passivierungsschicht als Abdeckung der aktiven Bereiche.

Der elektrisch leitende Ritzrahmen ermöglicht in einfacher Weise eine Hochfrequenzverlustmessung der entsprechenden Implantation mittels einer M-Gauge-Meßvorrichtung. Dabei wird der mittlere Verlust-Schichtwiderstand des Halbleiter-Bauelements gemessen, ohne daß äußere elektrische Anschlüsse bzw. Kontakte vorhanden sein müssen.

Die Erfindung ist ohne großen Aufwand realisierbar. Die ohnehin vorhandenen Masken zur Erzeugung von Strukturen beispielsweise mittels Implantation bedürfen nur einer zusätzlichen Änderung, damit auch der Ritzrahmen implantiert werden kann.

Der Ritzrahmen ist vorteilhafterweise elektrisch leitend verbunden mit Halbleiter-Zonen, die später mit zu belichtendem Fotolack (oberhalb von implantierten Bereichen) bedeckt sind.

Der Ritzrahmen geht auf der Halbleiterscheibe vorteilhafterweise durch bis zum Rand der Halbleiterscheibe. Am Rand der Halbleiterscheibe wird der elektrisch leitende Ritzrahmen mit elektrisch leitenden Klammern, beispielsweise aus Metall, mit dem elektrisch leitenden Halter des Wafer-Halters zum Abführen der Ladungen verbunden.

Die obenerwähnte M-Gauge-Meßvorrichtung zur Hochfrequenzverlustmessung mißt die Schichtleitfähigkeit an der Oberfläche des Halbleiterbauelements über Hochfrequenzverluste. Wenn der Ritzrahmen implantiert ist, wird ein besonders günstiges Meßsignal erzielt.

Zur Erzeugung eines elektrisch leitenden Ritzrahmens muß der Ritzrahmen nicht unbedingt implantiert werden. Wenn ein Halbleitersubstrat, beispielsweise eine Halbleiterscheibe mit einer Epitaxie-Schicht eine bereits elektrisch leitende Epitaxie-Schicht aufweist, wird durch entsprechende Führung von Ätzprozeßen der Ritzrahmen elektrisch leitend gehalten. Beispielsweise kann im Ritzrahmenbereich wenigstens ein Teil einer Epitaxie-Schicht-Struktur (wenigstens ein Teil einer Epitaxie-Schicht bei mehreren übereinander angeordneten Epitaxie-Schichten) stehengelassen werden.

Die Erfindung bietet nur Vorteile und ist mit keinen Nachteilen für die Halbleiterbauelemente verbunden.

Die Erfindung ist besonders vorteilhaft anwendbar, wenn zur Herstellung des Halbleiterbauelements, beispielsweise bei der Gate-Metallisierung bei Feldeffekttransistoren, ein Lift-off-Prozeß verwendet wird. Solche Lift-off-Prozesse sind bei der Herstellung von Metallisierungen bei Halbleiterbauelementen üblich (US-PS 4 377 030).

Die Erfindung ist besonders vorteilhaft anwendbar beim Korpuskularstrahl-Schreiben von justierten Feinstrukturen. Solche Verfahren sind beispielsweise beschrieben in Electronics Letters, 11. Juni 1981, Band 17, Nr. 12, S. 429-430; IEEE Transactions on Electron Devices, Band ED 32, Nr. 6, Juni 1985, S. 1042-1046; J. Vac. Sci. Technol. B 5 (1), Jan/Feb 1987, S. 211-214; IEEE Electron Device Letters, Band EDL-4, Nr. 2, Februar 1983, S. 42-44.

Die Erfindung wird im folgenden anhand der Zeichnung näher erläutert.

FIG 1 bis 8 erläutern ein Verfahren zur Herstellung eines Halbleiterbauelements, bei dem ein Ritzrahmen nach der Erfindung hergestellt wird.

FIG 9 und 10 erläutern einen Ritzrahmen nach der Erfindung und dessen Verwendung.

Die Erfindung ist besonders vorteilhaft anwendbar bei der Herstellung von Feldeffekttransistoren mit mittels Elektronenstrahl geschriebenen Gates. Die Erfindung ermöglicht die Herstellung von rauscharmen Galliumarsenid-MESFETS oder HEMTS.

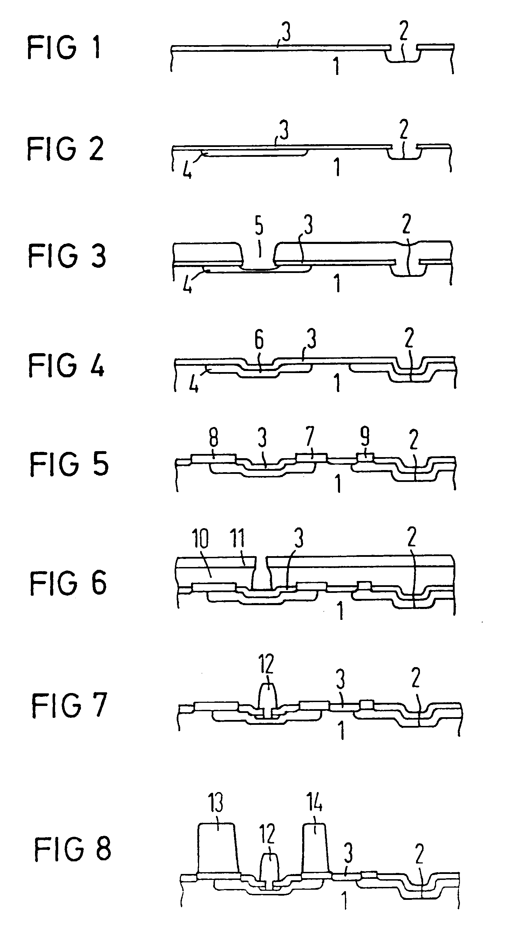

FIG 1 bis 8 erläutern die Herstellung eines Halbleiterbauelements mit einem Ritzrahmen 2 nach der Erfindung. Die Herstellung der Strukturen erfolgt dabei im Mix- und Match-Verfahren, d. h. die Gate-Ebene wird mit Hilfe von Elektronenstrahllithographie struktriert und die übrigen Ebenen werden in konventioneller Kontaktlithographie strukturiert. Die Elektronenstrahllithographie kann unter Verwendung des Philips-Schreibers EBPG-4 oder jedes anderen Elektronenstrahlschreibers erfolgen.

Die Erfindung ermöglicht die Optimierung der Elektronenstrahllithographie. Zum Schreiben des Gates kann beispielsweise ein Zwei-Lagen-PMMA-Prozeß oder eine andere Lacktechnik verwendet werden. Der in den FIG 1 bis 8 angegebene Herstellungsprozeß ist stabil gegenüber Nachfolgeprozessen. Es werden Lacköffnungen kleiner als 0,3 Mikrometer und Gatelängen (bezogen auf die Metallisierung) kleiner als 0,35 Mikrometer erzielt.

Es werden mit solchen Gates bei Galliumarsenid-MESFETs Rauschzahlen von typisch 1, 2 dB bei 12 GHz erzielt.

Gatelängen kleiner als 0,4 Mikrometer lassen sich mit lichtoptischer Lithographie nicht reproduzierbar erreichen. Daher wird zur Strukturierung ein Elektronenstrahlschreiber verwendet. Dabei wird ein Zwei-Lagen PMMA (Polymethyl-Methacrylat)-Systems verwendet. Es können jedoch auch Ein- und Drei-Lagen-Fotolack-Systeme Verwendung finden. Es können auch Gatelängen kleiner als 0,25 Mikrometer verwirklicht werden.

Zur Vermeidung von Aufladungen beim Suchen der Justiermarken 9 und beim Schreiben der Struktur 16 werden die Flächen, die mit dem Elektronenstrahl in Berührung gelangen, implantiert und mit dem elektrisch leitenden Ritzrahmen 2 elektrisch leitend verbunden. Für den Zweck der Erfindung kann es bereits genügen, wenn Flächen, die in der Nähe von Auftreff-Flächen des Elektronenstrahls liegen, elektrisch leitend mit dem Ritzrahmen verbunden sind. Solche Flächen in der Nähe von Auftreff-Flächen wirken dann wie Abführelektroden. Die ggf. nichtimplantierte Gatezuführungsfläche 17 beispielsweise ist den implantierten Source- und Drain-Zonen direkt benachbart; Ladungen können über diese zum angeschlossenen Ritzrahmen 2 abfließen. Es kann für die Zwecke der Erfindung auch bereits genügen, wenn nur der Ritzrahmen 2 quasi als Abschirmelektrode dient. Es können jedoch auch die Auftreff-Flächen 9, 16 des Elektronenstrahls elektrisch leitend mit dem Ritzrahmen 2 verbunden sein. Solche elektrisch leitende Verbindungen können gegebenenfalls nach einem Verfahrensschritt (Belichten des Fotolacks) wieder aufgetrennt werden.

Besondere Beachtung wird der Ausbildung strukturgenauer, lift-off-fähiger Fotolack-Kanten geschenkt. Bei Versuchen hat sich gezeigt, daß sich dies in optimaler Weise mit der beschriebenen Fotolack-/Belichtungs-Kombination erreichen läßt, falls Aufladungen durch den erfindungsgemäß leitend gemachten Ritzrahmen vermieden werden. Solche Aufladungen würden sonst aufgrund ihrer elektronenoptischen Wirkung der Strukturtreue und dem Kantenprofil abträglich sein. Dies gilt auch beim Suchen der Justiermarke 9 durch den Elektronenstrahl. Die Dosis, mit der der Elektronenstrahlschreiber über die zu suchende Marke 9 rastert, ist nicht beliebig wählbar. Die Erfindung ermöglicht jedoch nun durch Vermeidung der Aufladungen, daß auch im Bereich der Justiermarken lift-off-fähige Lackkanten vorhanden sind.

Beim Ausführungsbeispiel werden nur der Gatestreifen 16 und ein Teil 17 der Gate-Anschlußpads mit dem Elektronenstrahl belichtet. Die großen Flächen der Gatepads 18 werden anschließend - zusammen mit Source 13 und Drain 14 - mittels Kontaktlithographie strukturiert, um ein unnötiges Anwachsen der Schreibzeit mittels Elektronenstrahlschreiber zu vermeiden. Größere Flächen könnten jedoch auch mit Elektronenstrahl mit anderer Dosis und/oder anderen Fotolacken belichtet werden.

Bei FIG 1 wird das Galliumarsenid-Substrat 1 mit einer Schicht 3 aus Siliziumnitrid mit einer Dicke von 50 nm beschichtet. Mit Hilfe von Fotolithographie werden zur Erzeugung des Ritzrahmens 2 zuerst die Nitridschicht 3 und sodann das Galliumarsenid-Substrat 1 geätzt.

Bei FIG 2 wird in den Bereichen 4 eine Kontaktimplantation mit Donator-Ionen durchgeführt. Gleichzeitig mit dieser Kontaktimplantation kann bereits der Ritzrahmen 2 mit implantiert werden. Diese Bereiche 4 dienen als aktive und Kontakt-Schichten des Halbleiterbauelements. Si-Implantationen mit Spitzen-Konzentrationen im Bereich von 10¹⁷ - 10¹⁸cm⁻³ können später durch Ausheilen fast vollständig aktiviert werden. Die Schicht-Dotierung der aktiven Zonen 4 kann auch zwischen 10¹² und 10¹⁵cm⁻² liegen.

Bei FIG 3 wird der Kanal-Recess 5 durchgeführt. Die nach dem Kanal-Recess zurückbleibenden Reste der Nitridschicht 3 werden entfernt. Die Oberfläche des Halbleitersubstrats 1 wird nochmals mit einer neuen Siliziumnitrid-Schicht (Siliziumnitrid-Cap) 3 von 50 nm Dicke versehen. Statt der Kanal-Recess-Ätzung kann die Kontaktimplantation bzgl. der Gebiete 5 auch bereits bei der Kontaktimplantation (FIG 2) selektiv begrenzt werden.

Der Kanal 6, 16, die Bereiche 23 für die Elektronenstrahl-Marke 9 und der Ritzrahmen 2 werden vorteilhaft gemeinsam gleichzeitig n-implantiert mit einer Dosis von 3 - 10 x 10¹¹cm⁻² bei einer Energie von 150 keV (FIG 4). Dadurch werden Aufladungen beim späteren Elektronenstrahlschreiben vermieden sowie die weiteren beschriebenen Vorteile erzielt.

Nach dem Ausheilen der Implantation werden die ohmschen Kontakte 7 für Drain und 8 für Source strukturiert (FIG 5). Dabei werden auch gleichzeitig metallische Justiermarken 9 für den Elektronenstrahlschreiber mit einer Metallisierung versehen (FIG 5).

Zur Durchführung der Elektronenstrahl-Gate-Strukturierung wird bei FIG 6 die Oberfläche des Halbleiterbauelements mit dem Zwei-Lagen-Fotolack 10, 11 versehen. Sodann wird die Fotolackstruktur mit Hilfe des Elektronenstrahlschreibers belichtet und anschließend entwickelt.

Vor dem Gate-Recess muß die Siliziumnitrid-Schicht 3 im Gatebereich geätzt werden.

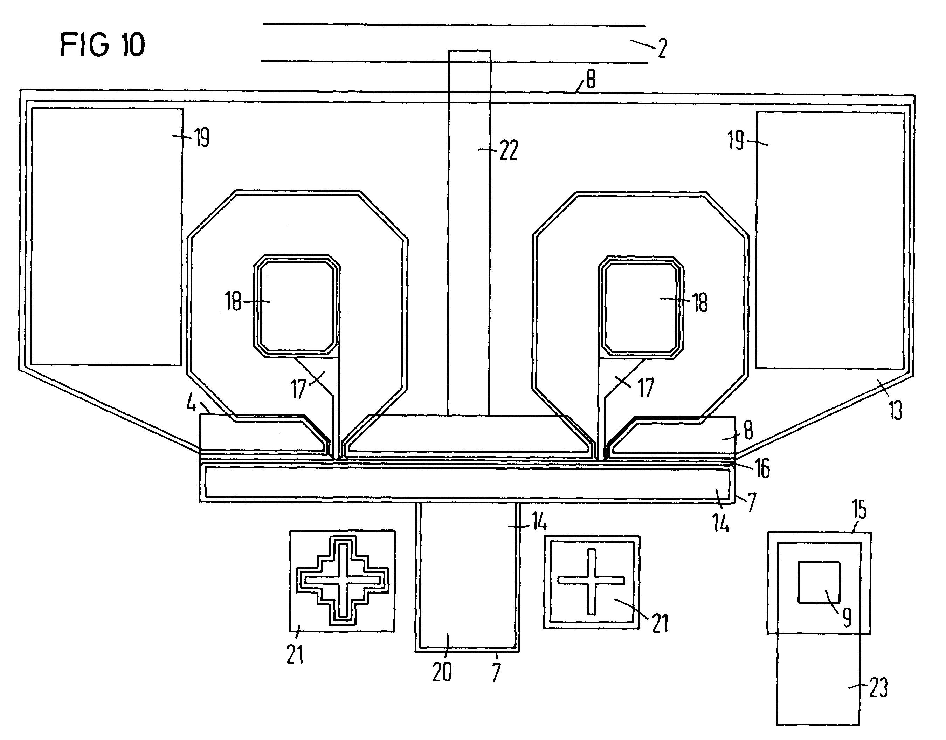

Nach Ätzung des Recess-Grabens (Gate-Recess) wird die Gatemetallisierung 12 mittels Lift-off-Verfahren hergestellt (FIG 7). Die Gate-Anschlüsse 18 und die Source- bzw. Drain-Anschlüsse 19, 20 werden aus Gründen der Schreibzeit-Minimierung mit einem eigenen zusätzlichen Fototechnik-Schritt strukturiert und ein Verstärkungsmetall auf Drain 14, Source 13 und Gate 17, 18 aufgebracht (FIG 8, 10).

Anschließend wird das Halbleiterbauelement passiviert.

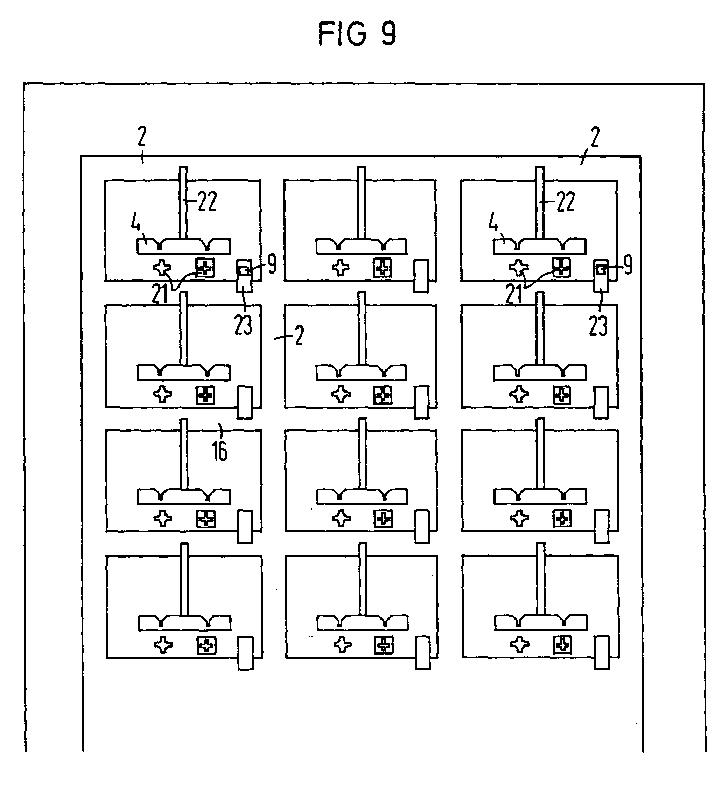

FIG 9 zeigt eine Halbleiterscheibe, auf der mehrere Halbleiterbauelemente gleichzeitig hergestellt werden. Um jedes Halbleiterbauelement herum befindet sich ein Ritzrahmen 2. Jedes Halbleiterbauelement besitzt Flächen 4, 23, die entweder direkt oder über Fläche 22 elektrisch leitend mit dem Ritzrahmen 2 verbunden sind. Außerdem besitzt jedes Halbleiterbauelement Flächen 21, die Justiermarken für optische Lithographie darstellen. Die Fläche 9 bildet die ohmsche Justiermarke für den Elektronenstrahl und die Fläche 4 bildet den aktiven Bereich eines Feldeffekttransistors und ist über eine Fläche 22 elektrisch leitend mit dem Ritzrahmen 2 verbunden.

FIG 10 zeigt in der Draufsicht einen Mikrowellen-Feldeffekttransistor mit einem Source-Bereich 13, mit einem Drain-Bereich 14 und mit einem Kanal 16, mit einem Drain-Anschluß 20, mit einem Source-Anschluß 19 und mit zwei Gate-Anschlüssen 18. Die Gate-Anschlüsse 18 sind über Anschlußstreifen 17 mit dem Gate 16 verbunden. Der Sourcebereich 13 ist über den Anschluß 22 elektrisch leitend mit dem Ritzrahmen 2 verbunden.

Die Erfindung ermöglicht Gatelängen unterhalb von 0,2 Mikrometer.

## Patentansprüche

1. Halbleiterscheibe mit einer Anzahl von Halbleiterbauelementen, die auf der Halbleiterscheibe im Scheibenverband hergestellt sind und Justiermarken (9) für einen Elektronenstrahl aufweisen, sowie mit einem Ritzrahmen (2), welcher die Halbleiterbauelemente rahmenförmiq umgibt und durch Dotierung der Halbleiterscheibe hergestellt ist, wobei die Justiermarken (9) elektrisch leitend mit dem Ritzrahmen (2) verbunden sind, **dadurch gekennzeichnet**,
daß der Ritzrahmen (2) eine höhere elektrische Leitfähigkeit als dessen Umgebung aufweist, und daß die Halbleiterbauelemente dotierte aktive Flächen (4) besitzen, die elektrisch leitend mit dem Ritzrahmen (2) verbunden sind.

2. Halbleiterscheibe nach Anspruch 1, **dadurch gekennzeichnet**,
daß der Ritzrahmen (2) eine Schicht-Konzentration von freien Ladungsträgern von größer als 10¹⁰ cm⁻² aufweist.

3. Halbleiterscheibe nach Anspruch 1, **dadurch gekennzeichnet**,
daß der Ritzrahmen (2) eine Schicht-Konzentration von freien Ladungsträgern von größer als 10¹¹ cm⁻² aufweist.

4. Halbleiterscheibe nach Anspruch 1, **dadurch gekennzeichnet**,
daß der Ritzrahmen (2) eine Schicht-Konzentration von freien Ladungsträgern von größer als 10¹² cm⁻² aufweist.

5. Halbleiterscheibe nach Anspruch 1, **dadurch gekennzeichnet**,
daß der Ritzrahmen (2) eine Schicht-Konzentration von freien Ladungsträgern von größer als 10¹⁴ cm⁻² aufweist.

6. Halbleiterscheibe nach einem der Ansprüche 1 bis 5, **dadurch gekennzeichnet**,
daß die aktiven Flächen (4) die Source- oder Drain-Zonen eines Feldeffekttransistors sind.

7. Verfahren zur Herstellung einer Halbleiterscheibe nach einem der Ansprüche 1 bis 6, **dadurch gekennzeichnet**,
daß der Ritzrahmen mittels Ionen-Implantation hergestellt ist.

8. Verfahren nach Anspruch 7, **dadurch gekennzeichnet**,
daß der Ritzrahmen gleichzeitig mit einer Implantation zur Herstellung der Halbleiterbauelemente implantiert wird.

## Claims

1. Semiconductor wafer with a number of semiconductor components which are produced on the semiconductor wafer in the wafer grid pattern and have alignment marks (9) for an electron beam, and with a clearing frame (2) which surrounds the semiconductor components as a frame and is produced by doping the semiconductor wafer, the alignment marks (9) being electrically conductively connected to the clearing frame (2), characterized in that the clearing frame (2) has a higher electrical conductivity than its surroundings, and in that the semiconductor components have doped active faces (4) which are electrically conductively connected to the clearing frame (2).

2. Semiconductor wafer according to Claim 1, characterized in that the clearing frame (2) has a layer concentration of free charge carriers of greater than 10¹⁰ cm⁻².

3. Semiconductor wafer according to Claim 1, characterized in that the clearing frame (2) has a layer concentration of free charge carriers of greater than 10¹¹ cm⁻².

4. Semiconductor wafer according to Claim 1, characterized in that the clearing frame (2) has a layer concentration of free charge carriers of greater than 10¹² cm⁻².

5. Semiconductor wafer according to Claim 1, characterized in that the clearing frame (2) has a layer concentration of free charge carriers of greater than 10¹⁴ cm⁻².

6. Semiconductor wafer according to one of Claims 1 to 5, characterized in that the active faces (4) are the source or drain regions of a field-effect transistor.

7. Method for producing a semiconductor wafer according to one of Claims 1 to 6, characterized in that the clearing frame is produced by means of ion implantation.

8. Method according to Claim 7, characterized in that the clearing frame is simultaneously implanted with an implantation for producing the semiconductor components.

## Revendications

1. Plaquette en semiconducteur, comportant un certain nombre de composants à semiconducteurs, qui sont produits en groupe sur la plaquette en semiconducteur et qui comportent des repères (9) d'ajustement destinés à un faisceau électronique, ainsi qu'un cadre (2) de découpe, qui entoure les composants à semiconducteurs à la manière d'un cadre et qui est produit par dopage de la plaquette en semiconducteur, les repères (9) d'ajustement étant reliés de manière conductrice de l'électricité au cadre (2) de découpe, caractérisée en ce que le cadre (2) de découpe a une plus grande conductivité électrique que ce qui l'entoure, et en ce que les composants à semiconducteurs ont des surfaces (4) dopées actives, qui sont reliées de manière conductrice de l'électricité au cadre (2) de découpe.

2. Plaquette de semiconducteur suivant la revendication 1, caractérisée en ce que le cadre (2) de découpe a une concentration de couche de porteurs de charge libres supérieure à 10¹⁰ cm⁻².

3. Plaquette de semiconducteur suivant la revendication 1, caractérisée en ce que le cadre (2) de découpe a une concentration de couche de porteurs de charge libres supérieure à 10¹¹ cm⁻².

4. Plaquette de semiconducteur suivant la revendication 1, caractérisée en ce que le cadre (2) de découpe a une concentration de couche de porteurs de charge libres supérieure à 10¹² cm⁻².

5. Plaquette de semiconducteur suivant la revendication 1, caractérisée en ce que le cadre (2) de découpe a une concentration de couche de porteurs de charge libres supérieure à 10¹⁴ cm⁻².

6. Plaquette de semiconducteur suivant une des revendications 1 à 5, caractérisée en ce que les surfaces (4) actives sont les zones de source ou les zones de drain d'un transistor à effet de champ.

7. Procédé de production d'une plaquette de semiconducteur suivant une des revendications 1 à 6, caractérisé en ce que le cadre de découpe est produit au moyen d'une implantation d'ions.

8. Procédé suivant la revendication 7, caractérisé en ce que le cadre de découpe est implanté en même temps qu'une implantation servant à produire les composants à semiconducteurs est effectuée.
